# DEMANDE DE BREVET EUROPEEN

(11) **EP 1 098 015 A1**
(43) Date de publication de la demande: **09.05.2001**
(21) Numéro de dépôt: 00410125.9
(22) Date de dépôt: 18.10.2000
(51) Int. Cl.: C23C 16/44, B01D 1/00, C23C 16/448

(54) **Dispositif évaporateur d'une installation de dépôt chimique en phase vapeur**

(30) Priorité: 08.11.1999 FR 9914246
(71) Demandeur: Joint Industrial Processors fo Electronics, 72430 Noyen sur Sarthe (FR)
(72) Inventeur: Brutti, Thierry, 38660 Le Touvet (FR); Pierret, Benoît, 38240 Meylan (FR); Guillon, Hervé, 38240 Meylan (FR)
(74) Mandataire: Hecké, Gérard

(57) **Abrégé**

Un dispositif évaporateur d'une installation de dépôt chimique en phase vapeur CVD, comprend une tête d'admission équipée au moins d'un injecteur 18 ayant une entrée 20 d'admission de précurseurs liquides 24 ou en solution. Un circuit d'injection de gaz vecteur est rendu actif simultanément avec l'injection du liquide, le gaz vecteur étant dirigé au voisinage de l'injecteur après avoir été réchauffé dans l'espace 124. Chaque injecteur 18 est refroidi individuellement par une circulation d'eau ou de fluide caloporteur. La chambre d'évaporation 16 comporte des résistances de chauffage destinés à assurer le changement d'état liquide/vapeur des précurseurs, et des moyens de déviation agencés pour que la distance parcourue par les gouttelettes et les vapeurs des précurseurs soit supérieure à la distance en ligne droite entre le nez de l'injecteur 18 et la tubulure de sortie.

## Description

### Domaine technique de l'invention

L'invention est relative à un dispositif évaporateur, notamment d'une installation de dépôt chimique en phase vapeur CVD, ou d'un réacteur de réaction chimique en phase vapeur, comprenant :
- une tête d'admission équipée au moins d'un injecteur ou une buse de pulvérisation ayant une entrée d'admission de précurseurs liquides ou en solution,
- un circuit de commande pour injecter périodiquement dans une chambre d'évaporation des gouttelettes de volume prédéterminé des précurseurs liquides, ou un flux continu ou pulsé d'aérosol,
- des moyens d'injection d'un gaz vecteur dans ladite chambre d'évaporation,
- des moyens de chauffage destinés à chauffer la chambre d'évaporation pour assurer le changement d'état liquide/vapeur des précurseurs liquides, ou du mélange solvants et précurseurs,
- et une tubulure de sortie destinée à envoyer les précurseurs injectés vaporisés vers un réacteur.

Le réacteur CVD est généralement équipé d'un système de pompage ou d'un évent pour créer un flux de vapeurs vers le réacteur.

### Etat de la technique

Le document FR-A-2707671 décrit un procédé et un dispositif d'introduction de précurseurs dans une enceinte de dépôt chimique en phase vapeur CVD. L'enceinte de dépôt est divisée en deux parties par un matériau poreux. La partie supérieure constitue l'évaporateur, et la partie inférieure à plus haute température forme la chambre de dépôt. Le séparateur poreux est réalisé en paille d'acier, qui laisse passer le flux gazeux, et éventuellement des gouttelettes non vaporisées par l'évaporateur. Or, il est primordial dans les procédés CVD que l'intégralité du liquide injecté soit évaporé avant d'entrer dans la chambre de dépôt.

Le document WO 96 20897 décrit un évaporateur équipé de plusieurs canaux remplis de billes, réalisées en verre, métal, céramique. Lors de la circulation dans les canaux, le liquide entre en contact avec ces billes, lesquelles forment des obstacles.

### Objet de l'invention

L'objet de l'invention consiste à réaliser un dispositif d'évaporation perfectionné permettant d'obtenir une volatilisation optimum des précurseurs liquides ou en solution après la phase d'injection, et évitant tout effet de condensation interne.

Le dispositif selon l'invention est caractérisé en ce que la tête d'admission comporte :
- au moins un orifice dans la partie centrale pour l'introduction de l'injecteur ou de la buse de pulvérisation,
- un circuit d'injection et de chauffage du gaz vecteur rendu actif simultanément avec l'injection du liquide, le gaz vecteur étant dirigé au voisinage de l'injecteur ou de la buse,
- et des moyens de refroidissement de l'injecteur ou de la buse, notamment par circulation d'eau ou de fluide caloporteur ou par soufflage d'air.

Selon une caractéristique de l'invention, la chambre d'évaporation renferme des moyens de déviation agencés pour que la distance parcourue par les gouttelettes et les vapeurs des précurseurs soit supérieure à la distance en ligne droite entre le nez de l'injecteur et la tubulure de sortie. Le tube est subdivisé en une pluralité de canaux élémentaires pour augmenter le trajet et la surface de chauffage dans la chambre d'évaporation. Le tube peut être en matériau métallique, notamment en acier inoxydable, ou en verre ou en quartz.

Selon un mode de réalisation préférentiel, les parois internes des canaux sont recouvertes d'un dépôt inerte chimiquement, par exemple du carbure de silicium ou de tungstène, pour éviter des réactions de décomposition catalytique des vapeurs en contact avec les parois métalliques. Des moyens de chauffage entourent coaxialement la surface latérale du tube, et comportent des résistances insérées dans des rainures usinées ménagées dans deux demi-coquilles en aluminium épousant le corps de l'évaporateur de manière à créer un chauffage indirect du tube. Une première zone de chauffage chauffe la bride supérieure, et une deuxième zone de chauffage chauffe le tube et la bride inférieure, la température dans chaque zone de chauffe étant contrôlée par un thermocouple.

Selon une autre caractéristique de l'invention, chaque injecteur ou buse de pulvérisation possède un circuit de refroidissement individuel, lequel est conformé par un espace annulaire rempli d'un liquide de refroidissement et entourant le corps de l'injecteur ou de la buse de pulvérisation.

Selon une autre caractéristique de l'invention, une collerette remonte jusqu'à la face inférieure de la bride supérieure dans la zone d'injection pour minimiser la surface accessible pour la rétro-diffusion et la condensation, le gaz vecteur étant injecté dans un volume annulaire agencé autour de la collerette où il se détend et se réchauffe avant d'être réinjecté dans l'espace au voisinage du nez de chaque injecteur ou buse de pulvérisation.

### Description sommaire des dessins

D'autres avantages et caractéristiques ressortiront plus clairement de la descriptiori qui va suivre d'un mode de réalisation de l'invention donné à titre d'exemple non limitatif, et représenté aux dessins annexés, dans lesquels:
- la figure 1 est vue en coupe longitudinale du dispositif évaporateur selon l'invention, lequel est équipé de trois injecteurs;
- la figure 2 montre une vue en coupe à échelle agrandie de la tête d'admission dotée d'un seul injecteur;
- la figure 3 représente une vue de dessus à échelle agrandie selon la ligne 3-3 de la bride d'injection de la figure 1;
- la figure 4 représente une vue de dessous à échelle agrandie selon la ligne 4-4 de la bride d'injection de la figure 1;
- la figure 5 est une vue en coupe selon la ligne 5-5 de la figure 1;
- la figure 6 est une vue identique de la figure 2 d'une variante de réalisation;
- les figures 7 et 8 sont des vues en élévation et en plan du four tubulaire de chauffage du dispositif évaporateur ;
- la figure 9 est une vue en élévation d'une autre variante du four ;
- la figure 10 est une vue en coupe d'un évaporateur à quatre injecteurs, un seul injecteur étant illustré ;
- les figures 11 et 12 sont des vues de dessus et de dessous de la bride de l'évaporateur de la figure 10.

### Description d'un mode de réalisation préférentiel

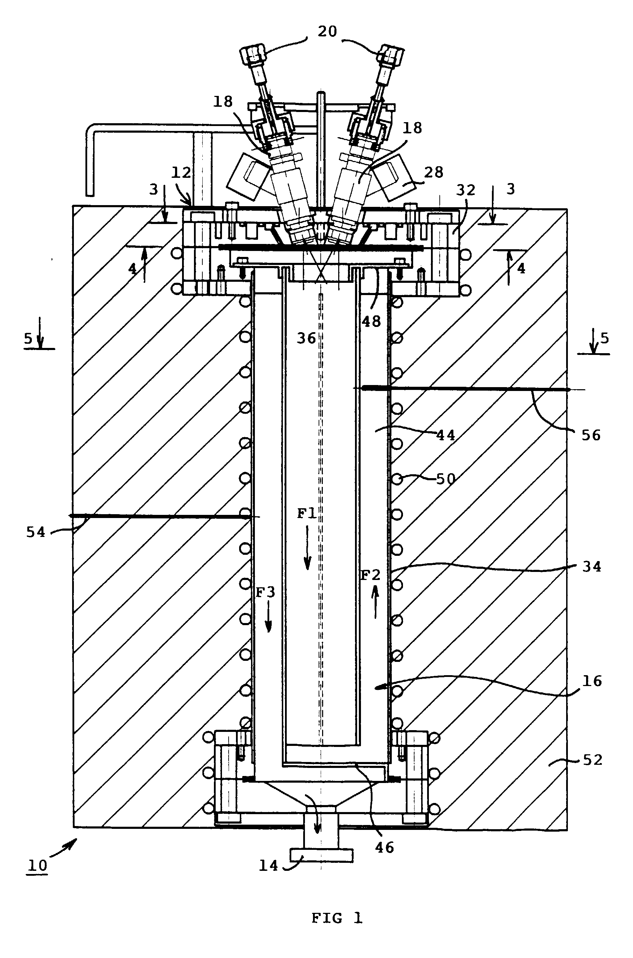

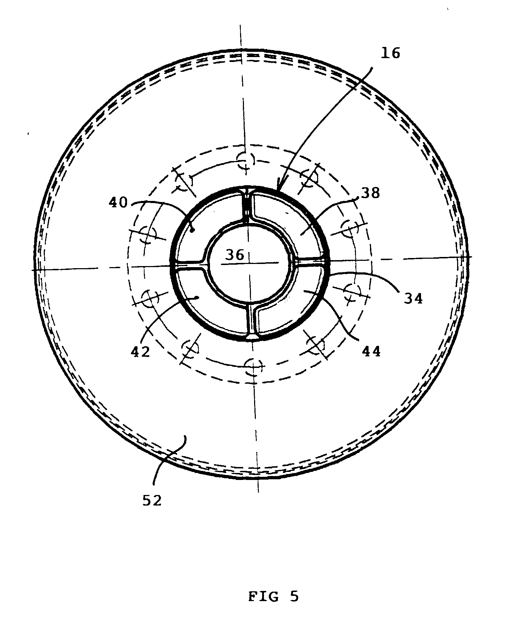

En référence aux figures 1 à 5, un dispositif évaporateur 10 d'une installation de dépôt chimique de couches minces en phase vapeur CVD, comporte une tête d'admission 12 raccordée à une tubulure de sortie 14 à travers une chambre d'évaporation 16 sous vide ou à pression atmosphérique.

La tête d'admission 12 est équipée d'au moins un injecteur 18 ayant une entrée 20 reliée à un réservoir 22 extérieur rempli de précurseurs liquide 24 ou en solution. La pression dans le réservoir 22 est supérieure à celle présente dans chambre d'évaporation 16, et chaque injecteur 18 envoie périodiquement des quantités prédéterminées de liquide 24 à l'intérieur de la chambre d'évaporation 16, dans laquelle s'effectue le changement d'état liquide/vapeur. L'injecteur 18 est formé par une électrovanne pilotée à l'ouverture et à la fermeture par un circuit de commande 26 à microprocesseur branché à un connecteur 28 de l'électrovanne. Le liquide injecté peut être un liquide pur ou un mélange de solvant et de soluté. Le volume de liquide injecté est parfaitement contrôlé par le circuit de commande 26, et est reproductible. L'injecteur 18 peut également être remplacé par. une buse de pulvérisation délivrant un débit continu ou pulsé d'aérosol. Dans ce cas, un débitmètre régulateur pour liquide est intercalé entre le réservoir 22 et la buse.

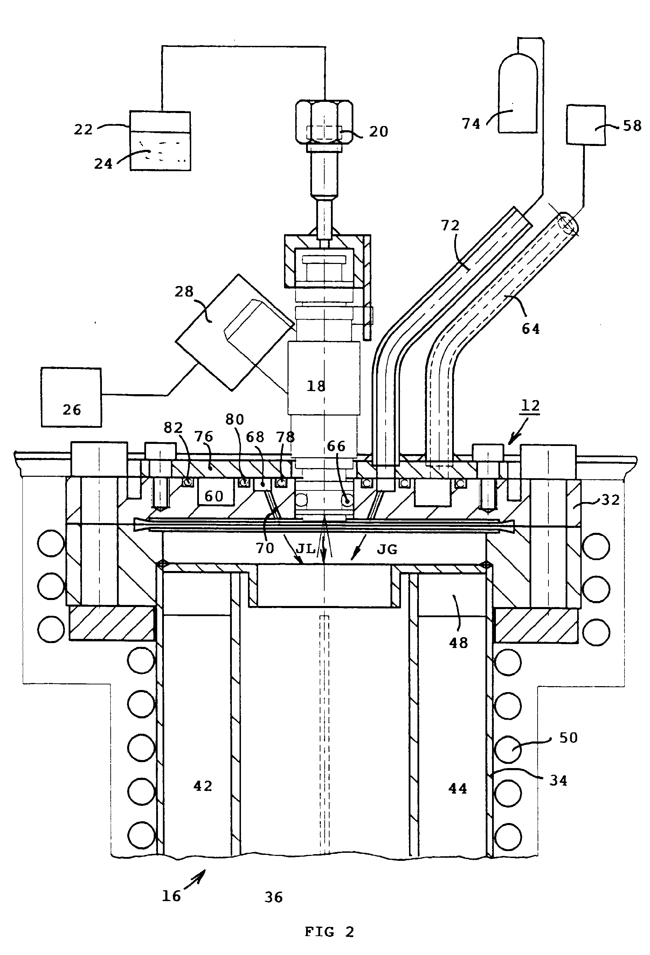

La figure 2 montre une tête d'admission 12 à un seul injecteur 18 s'étendant dans la direction longitudinale au-dessus de la chambre d'évaporation 16 cylindrique. Le nez 30 de l'injecteur 18 envoie un jet de liquide JL dirigé coaxialement dans la chambre d'évaporation 16.

Dans l'exemple de réalisation des figures 1, 3 et 4, la tête d'admission 12 comporte trois injecteurs 18 montés à inclinaison dans la partie centrale d'une bride 32 cylindrique. Les trois jets de liquide JL convergent vers la partie centrale à l'entrée de la chambre d'évaporation 16.

L'angle d'inclinaison des injecteurs 18 par rapport à l'axe longitudinal peut être compris entre 0 et 90°.

La tubulure de sortie 14 est prévue pour être raccordée par une ligne chauffée à un réacteur de dépôt chimique en phase vapeur CVD (non représenté), lequel est équipé d'un système de pompage ou d'un évent permettant d'engendrer un flux de vapeurs du dispositif évaporateur 10 vers le réacteur. Dans le réacteur est placé un substrat sur lequel doit s'effectuer le dépôt.

L'agencement du dispositif évaporateur 10 permet d'assurer l'évaporation totale du liquide injecté avant l'échappement final par la tubulure de sortie 14. La chambre d'évaporation 16 est munie à cet effet de moyens de déviation pour que la distance parcourue par les gouttelettes ou les vapeurs soit supérieure à la distance en ligne droite entre le nez 30 de l'injecteur 18 et la tubulure de sortie 14.

La chambre d'évaporation 16 est formée à titre d'exemple par un tube 34 métallique en acier inoxydable, subdivisé par usinage en une pluralité de canaux internes 36, 38, 40, 42, 44 s'étendant dans la direction longitudinale du tube. Le liquide est injecté depuis chaque injecteur 18 dans le canal central 36, et les gouttelettes et les vapeurs descendent (flèche F1, figures 1) en cours d'évaporation jusqu'à la partie inférieure où elles sont déviées par une première pièce de guidage 46 vers deux canaux voisins 38, 44. Après la remontée (flèche F2) jusqu'à la partie supérieure, elles sont déviées à nouveau par une deuxième pièce de guidage 48 pour emprunter les deux autres canaux 40, 42 dans le sens descendant (flèche F3) jusqu'à la tubulure de sortie 14. Un tel chemin en chicane permet d'augmenter le trajet et la surface de chauffage dans la chambre d'évaporation 16. Le volume des cinq canaux 36, 38, 40, 42, 44 du tube 34 permet d'atténuer au niveau du réacteur CVD les effets d'augmentation de pression dans la chambre d'évaporation 16 dus à l'évaporation du liquide.

Il est clair que la chambre d'évaporation 16 peut être réalisée avec d'autres matériaux, notamment des tubes en verre ou en quartz soudés entre eux.

L'effet d'évaporation du liquide peut également être augmenté en disposant dans les canaux 36, 38, 40, 42, 44, une pluralité de grilles métalliques ou de plaquettes de verre fritté poreux, s'étendant parallèlement entre elles et selon une direction perpendiculaire au flux de liquide et vapeurs. La présence de ces grilles ou plaquettes additionnelles le long du trajet de circulation du liquide diminue la taille des gouttelettes du liquide, et augmente la surface chauffée de la chambre d'évaporation 16.

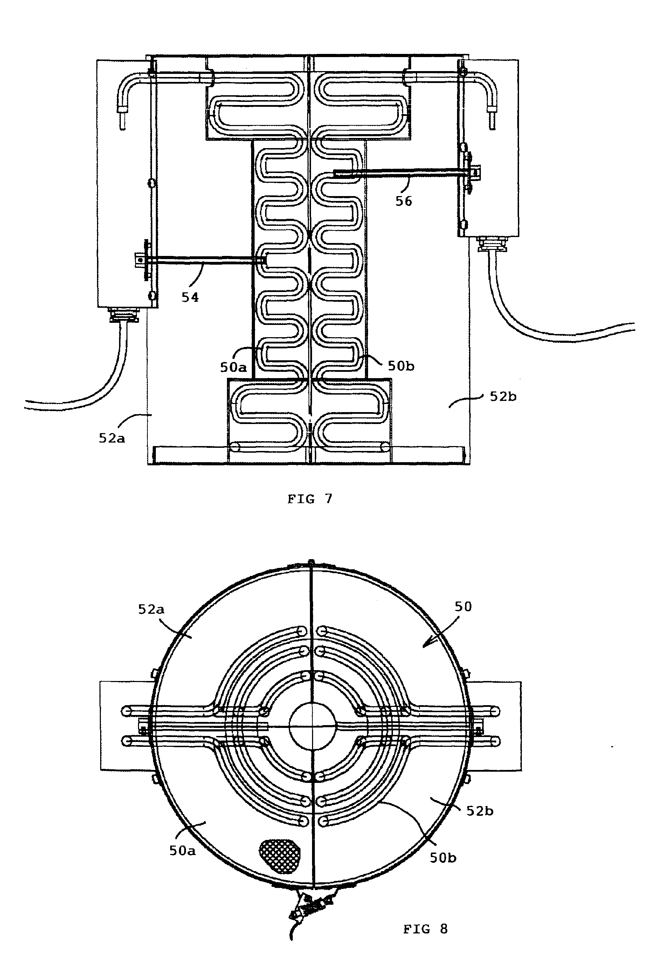

Le dispositif évaporateur 10 comporte de plus des moyens de chauffage 50 logés dans une enveloppe 52 tubulaire en matériau isolant thermique entourant coaxialement la surface latérale du tube 34. Sur les figures 7 et 8, l'enveloppe 52 est constituée par l'accolement de deux demi-coquilles 52a, 52b de sections semi-cylindriques, ayant chacune une surface interne de réception d'une résistance électrique 50a, 50b s'étendant sur toute la hauteur du dispositif évaporateur 10. Les deux résistances 50a, 50b des moyens de chauffage 50 peuvent être connectées en série ou en parallèle en fonction de la puissance électrique souhaitée. Le dispositif évaporateur 10 comprend de plus une paire de thermocouples 54, 56 logés dans l'enveloppe 52 pour capter la température en deux endroits de la chambre 16. Le thermocouple 56 placé à l'intérieur du tube, sert à réguler la température de dispositif évaporateur 10. L'autre thermocouple 54 permet de surveiller la température de la résistance 50.

L'agencement coaxial des deux demi-coquilles 52a, 52b du four autour de la chambre d'évaporation 16 permet d'obtenir un ensemble compact, et facilement démontable lors des opérations de nettoyage, notamment de la chambre d'évaporation 16.

La totalité de la zone de chauffage autour du tube 34 est isolée thermiquement du milieu extérieur par l'enveloppe 52 de manière à augmenter le rendement thermique du système. Avec une seule zone de chauffage, on obtient ainsi un gradient de température positif le long du parcours des vapeurs, lequel s'établit depuis le coeur de la chambre d'évaporation 16 dans le canal 36, vers les canaux externes 38, 40, 42, 44.

Le chauffage du liquide ne doit intervenir qu'à partir du moment où il a été injecté dans la chambre d'évaporation 16. Il suffit de prévoir des moyens de refroidissement de chaque injecteur 18 ou buse de pulvérisation, soit par l'intermédiaire d'un circuit de refroidissement 58 à eau ou à fluide caloporteur, soit par l'action d'un ventilateur (non représenté) soufflant de l'air vers le bride 32.

Sur les figures 2 à 4, la bride 32 de la tête d'admission 12 est dotée à cet effet d'une gorge 60 annulaire agencée autour des orifices 62 de réception des injecteurs 18. La gorge 60 est reliée par des canalisations 64 au circuit de refroidissement 58 de manière à refroidir les injecteurs 18. Les orifices 62 traversent toute l'épaisseur de la bride 32, et les injecteurs 18 sont introduits dans les orifices 62 avec interposition d'un joint d'étanchéité 66. Lors du passage du fluide de refroidissement dans la gorge 60, les injecteurs 18 restent froids.

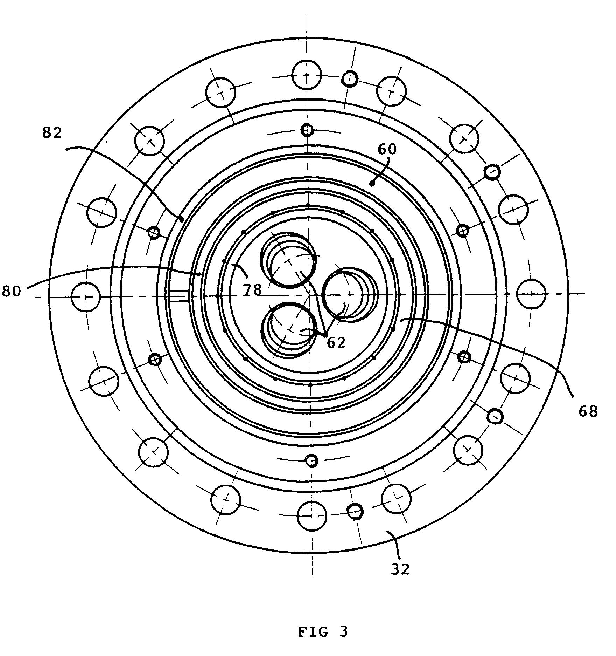

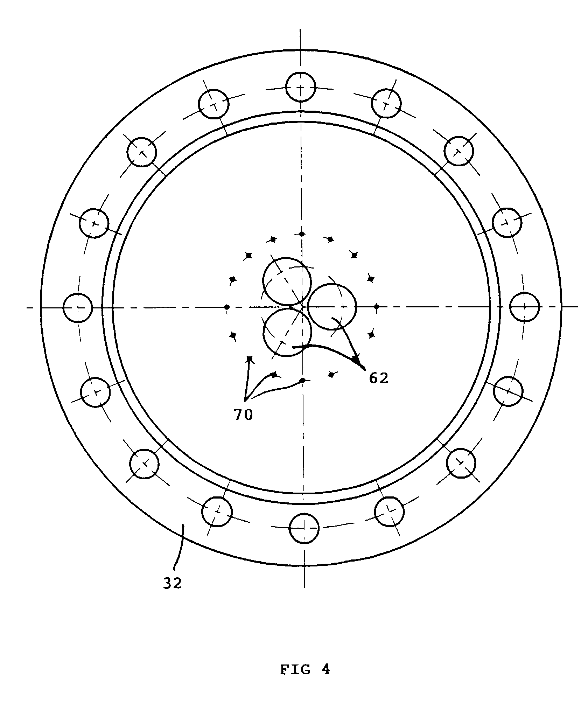

Pour éviter toute condensation des produits évaporés sur une zone froide à l'intérieur de la chambre d'évaporation 16, un gaz vecteur est envoyé dans cette dernière simultanément avec l'injection de liquide. Le circuit de gaz comporte une saignée 68 annulaire ménagée dans la bride 32 entre la gorge 60 et les orifices 62. Le fond de la saignée 68 communique avec la chambre d'évaporation 16 par des trous 70 répartis uniformément sur toute la circonférence de l'anneau pour l'injection de jets JG de gaz vecteur. L'alimentation en gaz de la saignée 68 s'effectue par une conduite 72 raccordée à un carter 74 rempli de gaz. Une gaine annulaire de gaz est ainsi présente autour du jet de liquide JL injecté par l'injecteur 18 de la figure 2 ou par les trois injecteurs 18 des figures 3 et 4. Un couvercle 76 est rapporté sur la bride 32 avec interposition de trois joints d'étanchéité 78, 80, 82 entre la gorge 60, la saignée 68 et les orifices 62.

L'injection simultanée du liquide et du gaz vecteur dans la chambre d'évaporation 16, permet une évaporation optimum et un transport efficace des vapeurs des précurseurs jusqu'à la zone de dépôt dans le réacteur. Pour des procédés spécifiques, la ligne de gaz peut être chauffée en amont de la conduite 72, et le gaz vecteur arrive dans la chambre d'évaporation 16 soit à la température ambiante, soit à une température supérieure.

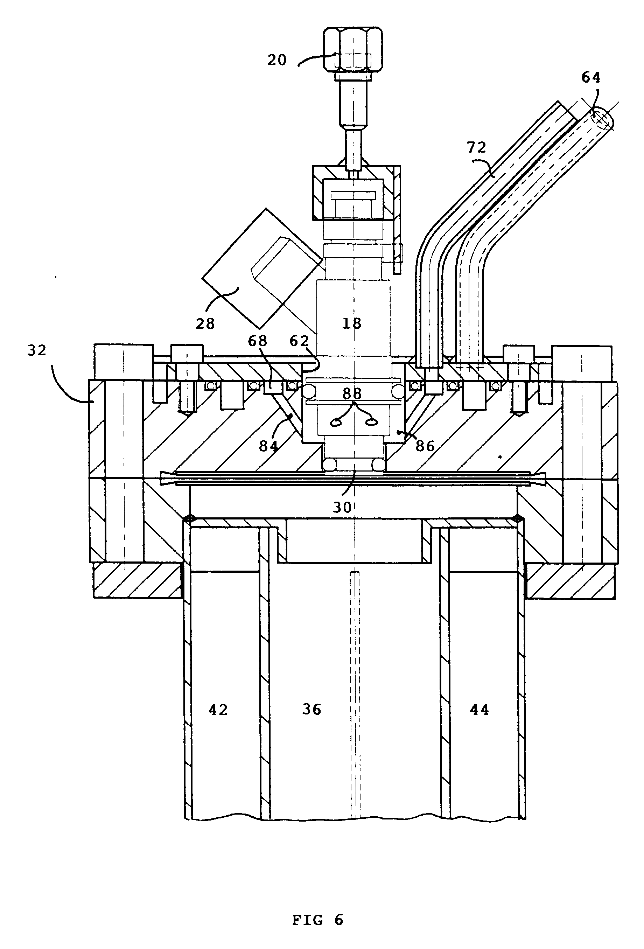

Selon la variante de la figure 6, l'injecteur 18 sert à injecter simultanément le gaz et le liquide sans les mélanger. La saignée 68 du circuit de gaz est connectée par des passages 84 à un espace 86 annulaire agencée autour du nez de l'injecteur 18. Des orifices 88 sont prévus dans le corps de l'injecteur 18 pour permettre au gaz de rentrer à l'intérieur de l'injecteur 18. Le nez 30 de l'injecteur 18 envoie alors deux jets combinés de liquide et de gaz dans la chambre d'évaporation 16.

Selon une variante (non représentée), l'injecteur ou les injecteurs 18 ne sont pas placés à la partie supérieure de la tête d'admission 12, mais sur le côté. Des plaques de déviation sont prévues dans la chambre d'évaporation pour assurer un trajet en zig-zag des précurseurs gazéifiés.

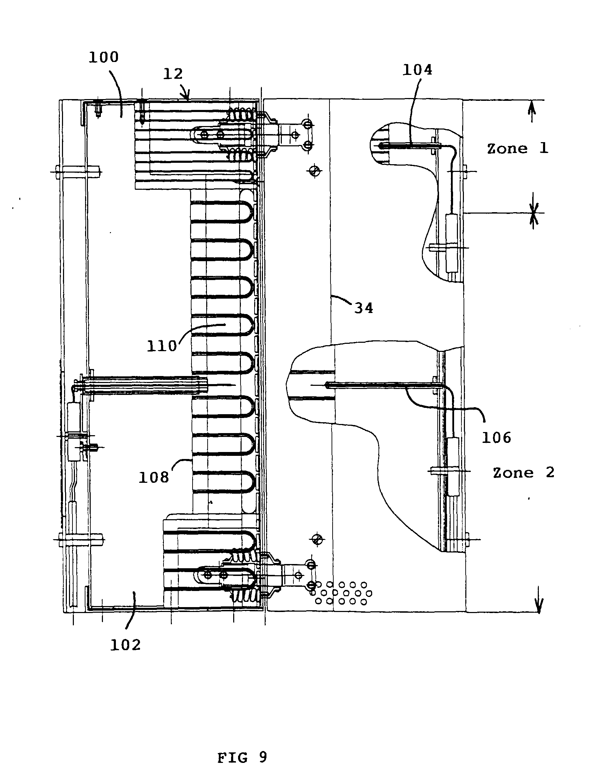

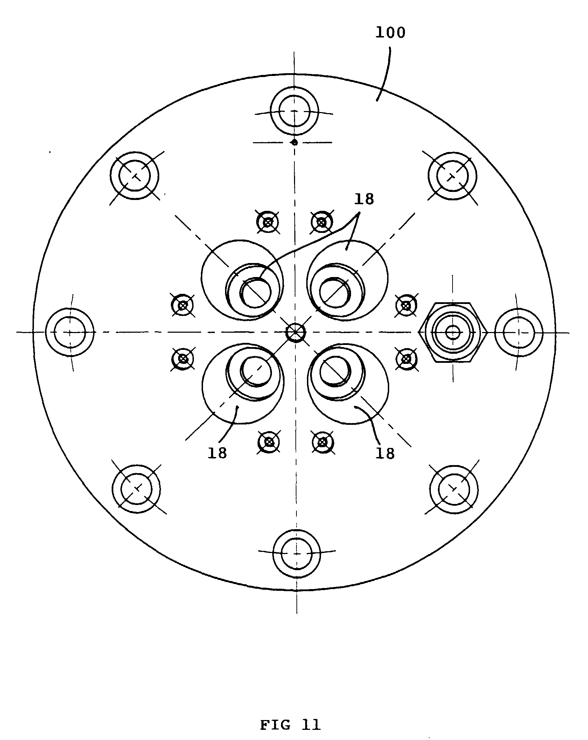

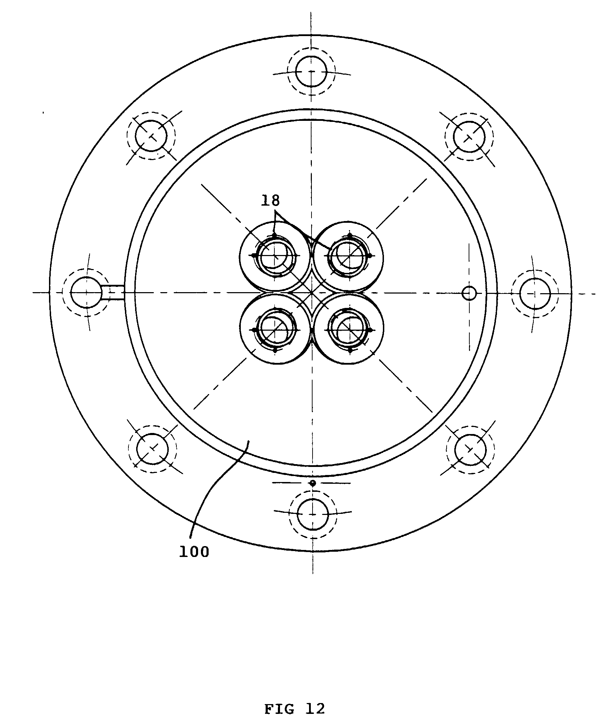

En référence à la variante illustrée aux figure 9 à 12, la recondensation dans l'évaporateur peut être évitée en le chauffant uniformément dans la direction radiale et la direction longitudinale. Chacun des quatre injecteurs 18 doit rester froid pour empêcher les décompositions des produits avant l'injection.

Le four de la figure 9 présente plusieurs zones de chauffe destinées à gérer indépendamment les apports d'énergie thermique sur la bride supérieure 100 de la tête d'admission 12, la bride inférieure 102 entourant la tubulure de sortie, et le tube 34. La première zone 1 chauffe la bride supérieure 100, et la deuxième zone 2 chauffe le tube 34 et la bride inférieure 102. La température dans chaque zones de chauffe 1,2 est contrôlée par un thermocouple 104, 106.

Pour améliorer le transfert thermique sur le corps de l'évaporateur, les résistances 108 sont insérées dans des rainures usinées ménagées dans deux demi-coquilles 110 en aluminium épousant la forme tubulaire du corps de l'évaporateur. Le chauffage indirect du tube en acier inoxydable de l'évaporateur à travers l'aluminium permet d'obtenir une température uniforme de l'évaporateur, étant donné que la conductibilité thermique de l'aluminium est plus élevée que celle de l'acier inoxydable.

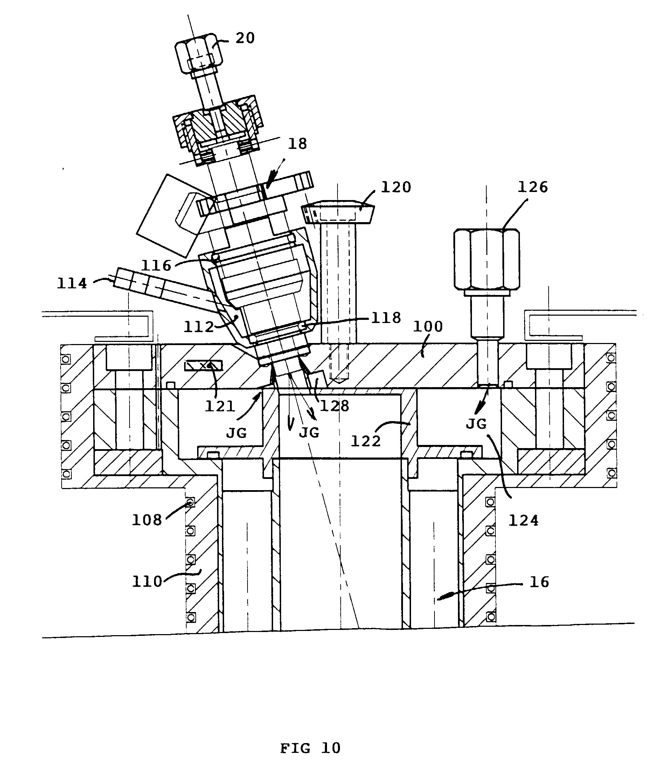

Sur les figures 10 à 12, au lieu de prévoir le circuit de refroidissement des injecteurs 18 dans la bride 100 de la tête d'admission 12, chaque injecteur 18 possède un circuit de refroidissement individuel, lequel est conformé par un espace 112 annulaire rempli d'un liquide de refroidissement introduit par un orifice 114. L'espace 112 est rendue étanche par interposition de deux joints 116, 118 avec le corps de chaque injecteur 18. Un plot 120 en acier inoxydable permet de fixer les injecteurs 18 et leurs circuits de refroidissement sur la bride 100. Il est ainsi possible de chauffer plus efficacement la bride 100 pour éviter la condensation. Des résistances 121 électriques peuvent être intégrées à cet effet dans la bride 100 supérieure pour engendrer un chauffage auxiliaire en plus de celui de la première zone 1 du four.

Une collerette 122 annulaire remonte jusqu'à la face inférieure de la bride 100 pour minimiser la surface accessible pour la rétro-diffusion et la condensation. L'évaporation du liquide injecté par les injecteurs 18 est optimisée en rendant le gaz vecteur le plus chaud possible, et en le faisant arriver au niveau du nez des injecteurs 18. Le gaz est injecté à travers un orifice 126 dans le volume annulaire 124 (flèche JG), où il se détend et se réchauffe avant d'être réinjecté dans l'espace 128 au voisinage du nez de chaque injecteur 18.

Les injecteurs 18 peuvent travailler en régime pulsé (cas d'un injecteur d'automobile), ou en régime continu (cas d'une buse de pulvérisation ultrasonore qui crée un flux d'aérosol continu).

Les parois internes de la chambre d'évaporation 16 peuvent être recouvertes d'un dépôt inerte chimiquement, par exemple du carbure de silicium ou de tungstène, pour éviter des réactions de décomposition des vapeurs en contact avec les parois métalliques. Ces réaction sont catalysées par la présence potentielle d'une fine couche d'oxydes à la surface de l'acier ou de l'aluminium. Le dépôt inerte permet de masquer ces oxydes.

L'évaporateur peut également être utilisé en chimie organique pour créer des vapeurs qui deviennent les réactifs de réactions chimiques en phase vapeur sans intervention d'un substrat.

## Revendications

1. Dispositif évaporateur d'une installation de dépôt chimique en phase vapeur CVD, ou d'un réacteur de réaction chimique en phase vapeur, comprenant :
- une tête d'admission (12) équipée au moins d'un injecteur (18) ou d'une buse de pulvérisation, ayant une entrée (20) d'admission de précurseurs liquides (24) ou en solution,
- un circuit de commande (26) pour injecter périodiquement dans une chambre d'évaporation (16) des gouttelettes de volume prédéterminé des précurseurs liquides (24), ou un flux continu ou pulsé d'aérosol,
- des moyens d'injection (74, 72, 68) d'un gaz vecteur dans ladite chambre d'évaporation (16),
- des moyens de chauffage (50) destinés à chauffer la chambre d'évaporation (16) pour assurer le changement d'état liquide/vapeur des précurseurs liquides (24), ou de la solution de solvant et de précurseurs,
- et une tubulure de sortie (14) destinée à envoyer les précurseurs injectés vaporisés vers un réacteur de l'installation de dépôt chimique CVD, caractérisé en ce que la tête d'admission (12) comporte :
- au moins un orifice (62) dans la partie centrale pour l'introduction de l'injecteur (18),
- un circuit d'injection et de chauffage du gaz vecteur rendu actif simultanément avec l'injection du liquide, le gaz vecteur étant dirigé au voisinage de l'injecteur (18),
- et des moyens de refroidissement de l'injecteur (18), notamment par circulation d'eau ou de fluide caloporteur ou par soufflage d'air.

2. Dispositif évaporateur selon la revendication 1, caractérisé en ce que la chambre d'évaporation (16) renferme des moyens de déviation agencés pour que la distance parcourue par les gouttelettes et les vapeurs des précurseurs soit supérieure à la distance en ligne droite entre le nez (30) de l'injecteur (18) et la tubulure de sortie (14).

3. Dispositif évaporateur selon la revendication 2, caractérisé en ce que les moyens de déviation de précurseurs liquides (24) sont formés par des chicanes à l'intérieur d'un tube (34) subdivisé en une pluralité de canaux (36, 38, 40 42, 44) élémentaires pour augmenter le trajet et la surface de chauffage dans la chambre d'évaporation (16).

4. Dispositif évaporateur selon la revendication 2, caractérisé en ce que le tube (34) est en matériau métallique, notamment en acier inoxydable ou en aluminium.

5. Dispositif évaporateur selon la revendication 1, caractérisé en ce que le tube (34) peut être réalisé en verre ou en quartz.

6. Dispositif évaporateur selon la revendication 3, caractérisé en ce que les parois internes des canaux (63, 38, 40 42, 44) sont recouvertes d'un dépôt inerte chimiquement, par exemple du carbure de silicium ou de tungstène, pour éviter des réactions de décomposition catalytique des vapeurs en contact avec les parois métalliques.

7. Dispositif évaporateur selon la revendication 3, caractérisé en ce que les moyens de chauffage (50) entourent coaxialement la surface latérale du tube (34) pour délimiter au moins une zone de chauffage isolée thermiquement de l'extérieur par une enveloppe (52) tubulaire en matériau isolant thermique.

8. Dispositif évaporateur selon la revendication 7, caractérisé en ce que les moyens de chauffage (50) comportent des résistances (108) insérées dans des rainures usinées ménagées dans deux demi-coquilles (110) en aluminium épousant le corps de l'évaporateur de manière à créer un chauffage indirect du tube 34.

9. Dispositif évaporateur selon la revendication 7, caractérisé en ce qu'il comporte une première zone de chauffe (1) qui chauffe la bride supérieure (100), et au moins une deuxième zone de chauffe (2) qui chauffe le tube (34) et la bride inférieure (102), la température dans chaque zone de chauffe (1,2) étant contrôlée par un thermocouple (104, 106).

10. Dispositif évaporateur selon la revendication 7, caractérisé en ce que l'enveloppe (52) en matériau isolant thermique est constituée par l'accolement de deux demi-coquilles (52a, 52b) semi-cylindriques, ayant chacune une surface interne de réception d'une résistance électrique (50a, 50b) s'étendant sur toute la hauteur du tube (34).

11. Dispositif évaporateur selon la revendication 1, caractérisé en ce que chaque injecteur (18) possède un circuit de refroidissement individuel, lequel est conformé par un espace (112) annulaire rempli d'un liquide de refroidissement.

12. Dispositif évaporateur selon la revendication 9, caractérisé en ce que au moins une résistance (121) électrique est intégrée dans l'une des brides supérieure (100) ou inférieure (102) pour engendrer un chauffage auxiliaire, en plus de celui de la première ou deuxième zone (1, 2) du four.

13. Dispositif évaporateur selon la revendication 9, caractérisé en ce qu'une collerette (122) annulaire remonte jusqu'à la face inférieure de la bride (100) dans la zone d'injection pour minimiser la surface accessible pour la rétro-diffusion et la condensation, le gaz vecteur étant injecté à travers un orifice (126) dans un volume annulaire (124) agencé autour de la collerette (122) où il se détend et se réchauffe avant d'être réinjecté dans l'espace (128) au voisinage du nez de chaque injecteur (18).

14. Dispositif évaporateur selon la revendication 1, caractérisé en ce qu'une saignée (68) est alimentée en gaz vecteur par un carter (74), et comporte dans le fond des trous (70) traversant la tête d'admission (12), et répartis uniformément sur toute la circonférence pour former une gaine annulaire de gaz vecteur autour du jet liquide injecté par l'injecteur (18).

15. Dispositif d'évaporateur selon la revendication 14, caractérisé en ce que la saignée (68) communique par des passages (84) avec un espace (86) annulaire disposé autour du nez de l'injecteur (18), et que des orifices (88) sont prévus dans le corps de l'injecteur (18) pour permettre au gaz d'être injecté par l'injecteur (18), mais dans un circuit indépendant de celui du liquide.
